Europäisches Patentamt

European Patent Office

Office européen des brevets

(19)

(11) Publication number: **0 115 287**
**A2**

(12) ## EUROPEAN PATENT APPLICATION

(21) Application number: **84100327.0**

(22) Date of filing: **13.01.84**

(51) Int. Cl.³: **H 01 L 29/62**
**H 01 L 21/28**

(30) Priority: **27.01.83 JP 11969/83**

(43) Date of publication of application:
**08.08.84 Bulletin 84/32**

(84) Designated Contracting States:
**DE FR GB**

(71) Applicant: **TOKYO SHIBAURA DENKI KABUSHIKI KAISHA**
**72, Horikawa-cho Saiwai-ku**
**Kawasaki-shi Kanagawa-ken 210(JP)**

(72) Inventor: **Kawaguchi, Tatsuzo**
**406 Toshiba-Tsurumi-Apartment 6-25 Toyooka-cho**
**Tsurumi-ku Yokohama-shi(JP)**

(74) Representative: **Lehn, Werner, Dipl.-Ing. et al,**
**Hoffmann, Eitle & Partner Patentanwälte Arabellastrasse**
**4 (Sternhaus)**
**D-8000 München 81(DE)**

(54) Semiconductor device including a metal silicide.

(57) A semiconductor device has a gate electrode (30) formed on a semiconductor substrate (21) through an insulation film (27) and having a two-layer structure wherein a polycrystalline silicon pattern (29) is deposited on a refractory metal silicide pattern (28).

F I G. 5F

EP 0 115 287 A2

- 1 -

## Semiconductor device including a metal silicide

The present invention relates to a semiconductor device and, more particularly, to a MOS transistor having an improved gate electrode.

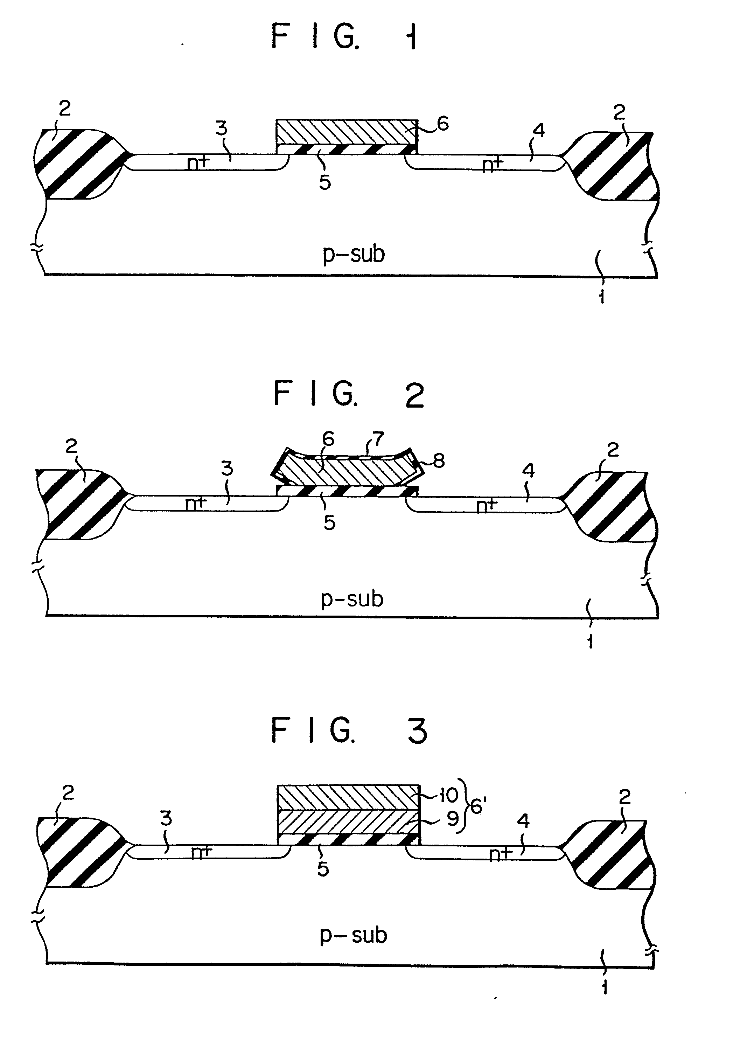

In a semiconductor device such as a MOS transistor, polycrystalline silicon (polysilicon) is conventionally used as a gate material. However, since a gate electrode made of polysilicon has a high resistance, a high-speed MOS transistor having a gate electrode made of a refractory metal silicide has been developed, as shown in Fig. 1. Referring to Fig. 1, reference numeral 1 denotes a p-type silicon substrate. A field oxide film 2 is formed in a surface layer of the substrate 1 to isolate a semiconductor element from another. An island region (i.e., element region) of the substrate 1 which is isolated by the field oxide film 2 has $n^+$-type source and drain regions 3 and 4 which are electrically isolated from each other. A gate electrode 6 of a refractory metal silicide is formed through a gate oxide film 5 in a portion of the substrate 1 which includes a channel region between the source and drain regions 3 and 4.

In the conventional technique, the gate electrode 6 is formed, and the $n^+$-type source and drain regions 3 and 4 are formed using the gate electrode 6 as a mask. Thereafter, in order to increase dielectric withstand voltages between the gate electrode 6 and the source region 3 and between the gate electrode 6 and the drain region 4, the resultant structure is subjected to thermal oxidation to form an oxide layer on the side wall of the gate electrode 6. However, when the gate electrode 6 comprises a refractory metal silicide, an oxide layer 7 is formed by annealing around the gate electrode 6, and overhangs 8 occur at the edge of the gate electrode 6 due to thermal stress, as shown in Fig. 2. In this manner, anomalous oxidation is caused. This is because the silicon in silicide is used up when the gate electrode 6 of refractory metal silicide is oxidized, and the reacted refractory metal silicide becomes chemically unstable. When these overhangs are formed and the MOS transistor is micropatterned, electrical characteristics of the element are greatly degraded. For example, a threshold voltage of the element greatly changes.

In order to prevent this drawback, as shown in Fig. 3, a MOS transistor is proposed wherein a gate electrode 6' having a polycide structure (a polysilicon pattern 9 and a refractory metal silicide pattern 10 are sequentially formed) is formed on a silicon substrate 1 through a gate oxide film 5. In the gate electrode 6' having the polycide structure, the polysilicon pattern 9 is sandwiched between the refractory metal silicide pattern 10 and the gate oxide film 5. When thermal oxidation is performed, silicon can be replenished from the polysilicon pattern 9 upon oxidation of the refractory metal silicide pattern 10, so that overhangs of the refractory metal silicide pattern 10 of the gate electrode 6' can be prevented.

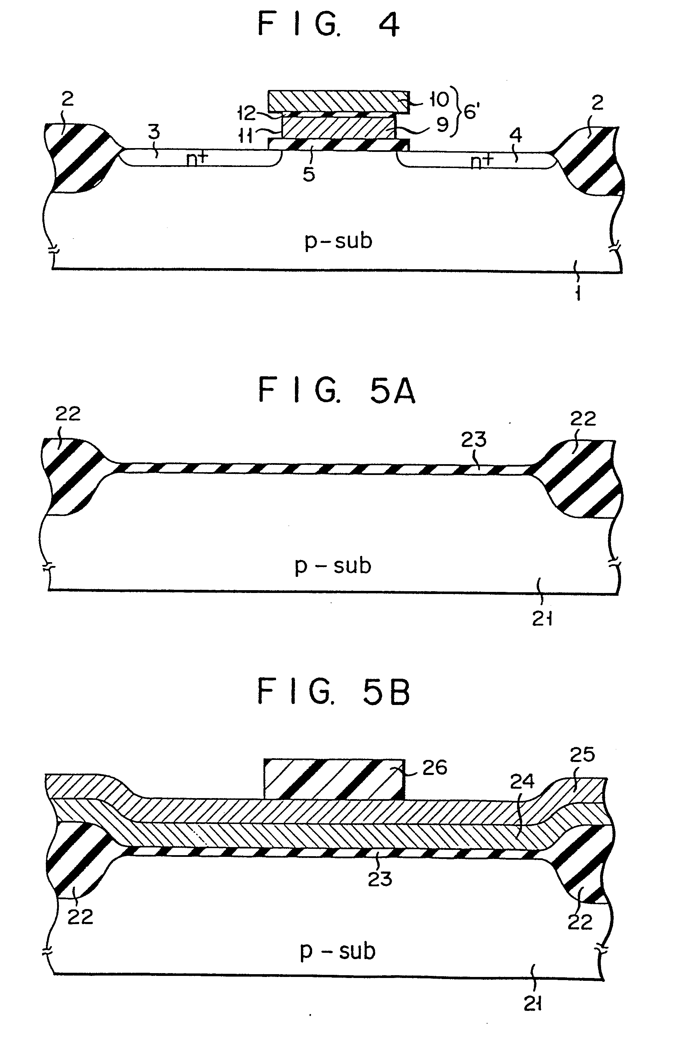

However, when the gate electrode of the polycide structure is formed by micropatterning a refractory metal silicide layer and a polysilicon layer, undercut portions 11 are formed in the polysilicon pattern 9, as shown in Fig. 4, thus degrading the element characteristics. Furthermore, when an impurity such as phosphorus is diffused in the polysilicon pattern 9 so as to decrease a sheet resistance, a thin oxide film 12 having a thickness of several tens of angstroms to several hundreds of angstroms is formed on the upper surface of the polysilicon pattern 9 (i.e., between the polysilicon pattern 9 and the refractory metal silicide pattern 10). As a result, a contact resistance is abnormally increased, and the electrical characteristics of the element are degraded.

It is an object of the present invention to provide a highly reliable semiconductor device which prevents anomalous oxidation of a refractory metal silicide pattern of a gate electrode.

It is another object of the present invention to provide a highly integrated semiconductor device which allows micropatterning of the gate electrode.

It is still another object of the present invention to provide a high-performance semiconductor device which can decrease a contact resistance between a refractory metal silicide pattern and a polysilicon pattern which constitute the gate electrode.

In order to achieve the above objects of the present invention, there is provided a semiconductor device wherein a two-layer gate electrode comprising a refractory metal silicide pattern and a polysilicon pattern is formed on a semiconductor substrate through an insulation film.

This invention can be more fully understood from the following detailed description when taken in conjunction with the accompanying drawings, in which:

Fig. 1 is a sectional view of an n-channel MOS transistor having a gate electrode of a refractory metal silicide;

Fig. 2 is a sectional view for explaining a problem of the MOS transistor shown in Fig. 1;

Fig. 3 is a sectional view of an n-channel MOS transistor having a polycide structure;

Fig. 4 is a sectional view for explaining a problem of the MOS transistor shown in Fig. 3;

Figs. 5A to 5F are sectional views for explaining the steps of forming an n-channel MOS transistor according to an embodiment of the present invention;

Fig. 6 is a graph showing rates of defective dielectric withstand voltages of the MOS transistors shown in Fig. 1 and 5F; and

Fig. 7 is a graph showing the rates of anomalous oxidation of the MOS transistors shown in Figs. 1 and 5F.

A method for manufacting an n-channel MOS transistor according to an embodiment of the present invention will be described with reference to Figs. 5A to 5F.

As shown in Fig. 5A, a p-type silicon substrate 21 was selectively oxidized to form a field oxide film 22. Thermal oxidation was then performed to form an oxide film 23 having a thickness of 300 $\overset{o}{A}$ in an island region (element region) of the substrate 21. This region was isolated by the field oxide film 22.

As shown in Fig. 5B, a molybdenum silicide layer 24 was deposited by sputtering, CVD or vacuum deposition to a thickness of 3,000 $\overset{o}{A}$ so as to cover the entire surface. A polysilicon layer was then deposited by LPCVD to a thickness of 3,000 $\overset{o}{A}$ on the molybdenum silicide layer 24. Thereafter, the resultant structure was placed in a $POC\ell_3$ atmosphere to diffuse phsphorus, so that a phosphorus-doped polysilicon layer 25 was formed. Subsequently, a resist pattern 26 was formed by photoetching on a portion of the phosphorus-doped polysilicon layer 25 corresponding to a gate electrode.

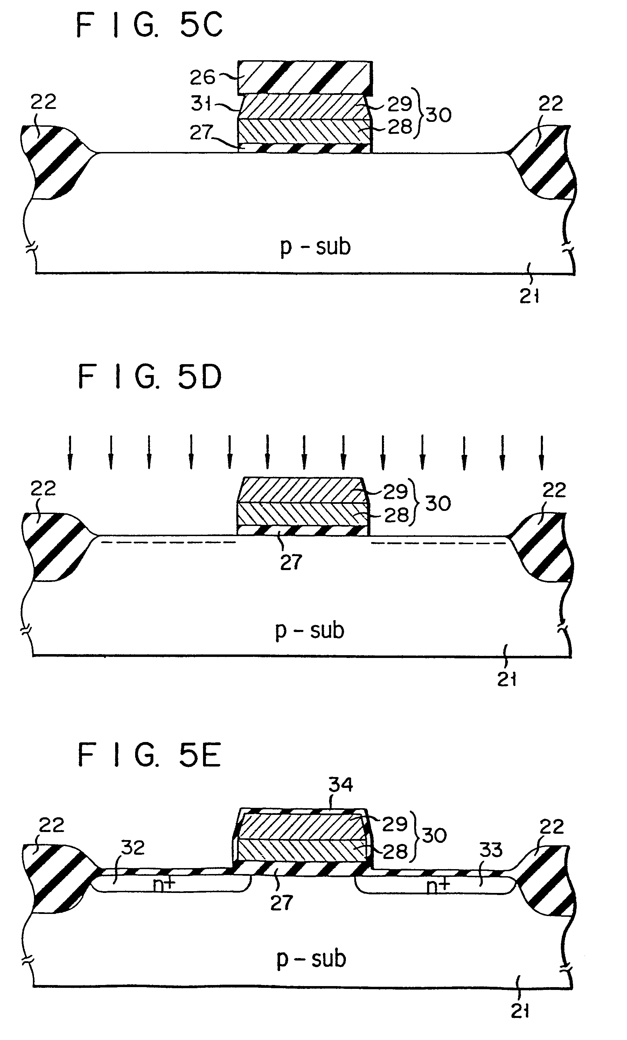

As shown in Fig. 5C, the phosphorus-doped polysilicon layer 25, the molybdenum silicide layer 24 and the oxide film 23 were sequentially etched by reactive ion etching (RIE) or isotropic ion etching by using the resist pattern 26 as a mask. A gate oxide film 27 was thus formed. A two-layer gate electrode 30 was formed by sequentially depositing a molybdenum silicide pattern 28 and a polysilicon pattern 29 on the gate oxide film 27. A tapered portion 31 was formed on the side wall of the polysilicon pattern 29 when reactive ion etching was performed.

As shown in Fig. 5D, after the resist pattern 26 was removed, an n-type impurity (e.g., arsenic) was selectively ion-implanted in the silicon substrate 21 using the gate electrode 30 and the field oxide film 22 as masks, and at an acceleration voltage of 40 keV and a dose of $3 \times 10^{15}$ $cm^{-2}$. The resultant structure was then thermal oxidation at a temperature of 800 to 1,000°C. In this case, as shown in Fig. 5E, the doped arsenic was activated and diffused to form $n^{+}$-type source and drain regions 32 and 33 in a surface area of the silicon substrate 21. At the same time, an oxide layer 34 was formed on an exposed surface portion of the silicon substrate 21 and on the side walls of the molybdenum silicide pattern 28 and polysilicon pattern 29, which latter two constituted the gate electrode 30.

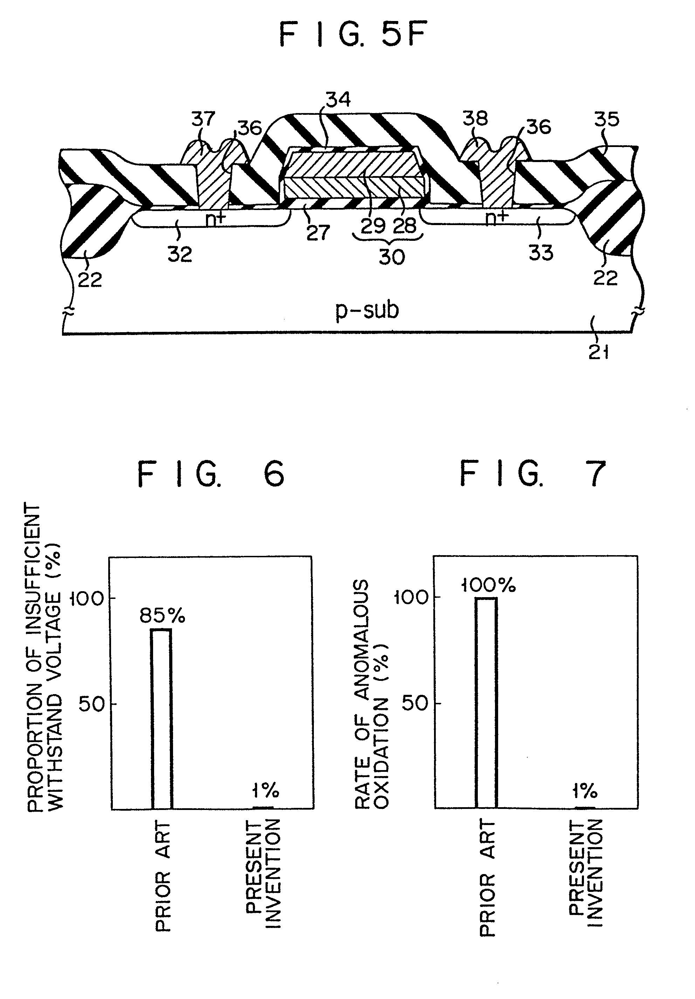

As shown in Fig. 5F, thereafter, a CVD-SiO film 35 was deposited to cover the entire surface. Contact holes 36 were formed in portions respectively corresponding to the source and the drain regions 32 and 33. An aluminum film was deposited to cover the entire surface and was patterned, so that Aℓ wire strips 37 and 38 were electrically connected to the source and drain regions 32 and 33 through the contact holes 36, respectively. Thus, an n-channel MOS transistor was prepared.

In the MOS transistor shown in Fig. 5F, the $n^{+}$-type source and drain regions 32 and 33 which are electrically isolated from each other are formed in the island region of the p-type silicon substrate 21 which is isolated by the field oxide film 22 from another island region. The two-layer gate electrode 30 obtained by sequentially forming the molybdenum silicide pattern 28 and the polysilicon pattern 29 on the gate oxide film 27 is formed on a portion of the silicon substrate 21 which includes the channel region between the source and drain regions 32 and 33. Furthermore, the oxide layer 34 is formed around the gate electrode 30 and the surfaces of the source and drain regions 32 and 33. Thereafter, the Aℓ wire strips 37 and 38 are respectively connected to the source and drain regions 32 and 33 through the CVD-SiO film 35.

The oxide layer 34 is formed on the side wall of the molybdenum silicide pattern 28 of the gate electrode 30 at the time of high-temperature thermal oxidation. Even if silicon elements are consumed from the molybdenum silicide pattern 28, the consumed silicon can be replenished from the polysilicon pattern 29 formed on the molybdenum silicide pattern 28. As a result, anomalous oxidation can be prevented even if thermal oxidation is performed at a high temperature. A good oxide layer 34 can be formed around the gate electrode 30, thereby effectively increasing the gate dielectric withstand voltage. The proportion of insufficient gate dielectric withstand voltages and the rate of anomalous oxidation were examined for the conventional MOS transistor (Fig. 1) having the refractory metal (molybdenum) silicide gate and the MOS transistor of the present invention. Results are shown in Figs. 6 and 7, respectively. The dielectric withstand voltage of the gate of the MOS transistor of the present invention and the yield (elimination of anomalous oxidation) can be greatly improved as shown in Figs. 6 and 7.

Since the gate electrode 30 has a two-layer structure wherein the polysilicon pattern 29 is formed on the molybdenum silicide pattern 28, the thin oxide film (Fig. 4) will not be formed between the polysilicon pattern and the molybdenum silicide pattern, even if a thin oxide film is inevitably formed on the polysilicon pattern 28 in order to decrease a resistance of the polysilicon pattern 29. As a result, an abnormal increase in contact resistance between the molybdenum silicide pattern 28 and the polysilicon pattern 29 which constitute the gate electrode 30 can be prevented, thereby improving the electrical characteristics of the transistor.

Furthermore, since the gate electrode 30 is formed such that the molybdenum silicide layer 24 and the phosphorus-doped polysilicon layer 25 are sequentially formed and are etched by RIE by using the resist pattern 26 as a mask, as shown in Figs. 5B and 5C, the formation of undercut portions as shown in Fig. 4 can be prevented. Furthermore, the tapered portion 31 can be formed on the upper layer (polysilicon pattern 29) of the gate electrode 30. As a result, the electrical performance of the transistor can be stabilized, and good step coverage can be obtained at the portion of the CVD-SiO film 35 (formed to cover the entire surface including the gate electrode 30) which corresponds to the gate electrode 30.

In the above embodiment, a molybdenum silicide pattern is used as the refractory metal silicide pattern. However, the refractory metal silicide pattern is not limited to this compound. For example, tungsten silicide, tantalum silicide, titanium silicide, platinum silicide and the like can be used as the refractory metal silicide so as to obtain the same effect as in the above embodiment.

In the above example, the polysilicon pattern comprises a phosphorus-doped polysilicon pattern. However, the polysilicon pattern may comprise an n-type impurity doped polysilicon pattern (e.g., arsenic- or antinomy-doped polysilicon pattern) or a p-type impurity doped polysilicon pattern (e.g., boron-doped polysilicon pattern).

In the above example, the MOS transistor comprises an n-channel MOS transistor. However, the present invention may also be applied to the manufacture of a p-channel MOS transistor, a CMOS or a MNOS (Metal Nitride Oxide Semiconductor).

As has been apparent from the above description, a high-performance, highly integrated, highly reliable semiconductor device can be obtained, which is capable of decreasing a contact resistance between the refractory metal silicide pattern and the polysilicon pattern which constitute the gate electrode, and wherein anomalous oxidation of the refractory metal silicide pattern of the gate electrode can be prevented, and the gate electrode can be micropatterned.

Claims:

1. A semiconductor device, characterized in that a gate electrode (30) is obtained by sequentially depositing a refractory metal silicide pattern (28) and a polycrystalline silicon pattern (29) on an insulation film (27) on a semiconductor substrate (21).

2. The device according to claim 1, characterized in that a refractory metal silicide of said refractory metal silicide pattern comprises one material selected from the group consisting of molybdenum silicide, tungsten silicide, tantalum silicide, titanium silicide, and platinum silicide.

3. The device according to claim 1, characterized in that said polycrystalline silicon pattern (29) contains an n-type impurity.

4. The device according to claim 1, characterized in that an oxide layer (34) is formed around said gate electrode (30) by thermally oxidizing said refractory metal silicide pattern (28) and said polycrystalline silicon pattern (29) which constitute said gate electrode (30).

5. The device according to claim 1, characterized in that a source region (32) of one conductivity type and a drain region (33) of the one conductivity type are formed in a surface layer of said semiconductor substrate (21) of the other conductivity type so as to be electrically isolated from each other, said gate electrode (30) having a two-layer structure of said refractory metal silicide pattern (28) and said polycrystalline silicon pattern (29) is formed through said insulation film (27) on a portion of said semiconductor substrate (21) which includes at least a channel region between said source region (32) and said drain region (33), and said oxide layer (34) is formed around said gate electrode (30).

F I G. 1

F I G. 2

F I G. 3

# FIG. 4

# FIG. 5A

# FIG. 5B

F I G. 5C

F I G. 5D

F I G. 5E

0115287

# F I G. 5F

# F I G. 6

# F I G. 7